# FASCICULE DE BREVET EUROPEEN

(11) **EP 1 249 939 B1**
(45) Date de publication et mention de la délivrance du brevet: **15.02.2006**
(21) Numéro de dépôt: 02290593.9
(22) Date de dépôt: 08.03.2002
(51) Int. Cl.: H03M 13/29, H03M 13/39

(54) **Procédé et dispositif d'optimisation, sous contrainte de performances, de la taille de blocs de données codées**
Verfahren und Vorrichtung zur Optimierung, unter Leistungsgebundenheiten, der Grösse von kodierten Datenblöcken
Method and device to optimize, under performance constraints, the size of coded data blocs

(30) Priorité: 19.03.2001 FR 0103787
(43) Date de publication de la demande: 16.10.2002
(73) Titulaire: Mitsubishi Electric Information Technology Centre Europe B.V., 1119 NS Schiphol Rijk (NL)
(72) Inventeur: Gueguen, Arnaud, Mitsubishi Electricité, 35700 Rennes (FR)
(74) Mandataire: Maillet, Alain

(56) Documents cités:
- EP-A- 1 128 589
- DE-C- 19 736 676
- FR-A- 2 747 255
- US-A- 5 761 248
- US-A- 6 044 116
- US-B1- 6 182 261

## Description

La présente invention concerne un procédé d'optimisation de taille de bloc de données codées destiné à être soumis à un décodage itératif, tel que celui mis en oeuvre dans un turbo-décodeur ou un turbo-égaliseur. EUe s'applique en particulier aux systèmes de télécommunication dits de troisième génération.

Le concept de turbo-code a été introduit par C. Berrou, A. Glavieux , P. Thitimajshima dans leur article "Near Shannon Limit Error - Correcting Coding and Decoding: Turbo-codes", ICC-1993, Conference Proceedings, pp. 1064-1070 et a fait, comme on le sait, l'objet de nombreux développements.

On rappelle que le turbo-codage résulte de la concaténation codes élémentaires séparées par des étapes d'entrelacement. Les codes élémentaires peuvent être de différents types : codes récursifs systématiques (notés RSC) pour les turbo-codes convolutifs ou codes en blocs (RS, BCH) pour les turbo-codes en bloc. Ces derniers ont été décrits par « R. Pyndiah, P. Combelles et P. Adde dans un article intitulé « A very low cornplexity block turbo décoder for product codes » publié dans Proc. of IEEE Globecom, pp. 101-105, 1996. Différents types de concaténation ont été envisagés comme la concaténation parallèle, dans laquelle la même information est codée séparément par chaque codeur après avoir été entrelacée et la concaténation série dans laquelle la sortie de chaque codeur est entrelacée avant d'être codée par le codeur suivant. Pour une description détaillée, on pourra se référer pour la concaténation parallèle à l'article de Berrou et al. précité et pour la concaténation série à l'article de S. Benedetto, G. Montorsi, D. Divsalar et F. Pollara, "Serial concaténation of interleaved codes : Performance analysis, design and itérative decoding", JPL TDA Progr. Rep., Vol. 42-126, Aug. 1996.

Le décodage d'un turbo-code est classiquement effectué au moyen d'un processus itératif encore appelé turbo-décodage, constitué d'une suite d'opérations de décodage élémentaires, chaque opération de décodage élémentaire recevant des valeurs d'entrée pondérées et fournissant des valeurs de sortie pondérées, relatives respectivement à l'entrée et (pour un turbo-code série) à la sortie de l'opération de codage élémentaire correspondante. Les valeurs d'entrée et de sortie pondérées traduisent les probabilités des symboles binaires ou M-aires en entrée et (pour les turbo-codes série) en sortie du codeur élémentaire correspondant. Des opérations de désentrelacement et d'entrelacement interviennent en fonction des opérations d'entrelacement effectuées au niveau du codage et permettent à chaque opération de décodage élémentaire de prendre en compte les données dans le même ordre que celui en entrée de l'opération de codage correspondante.

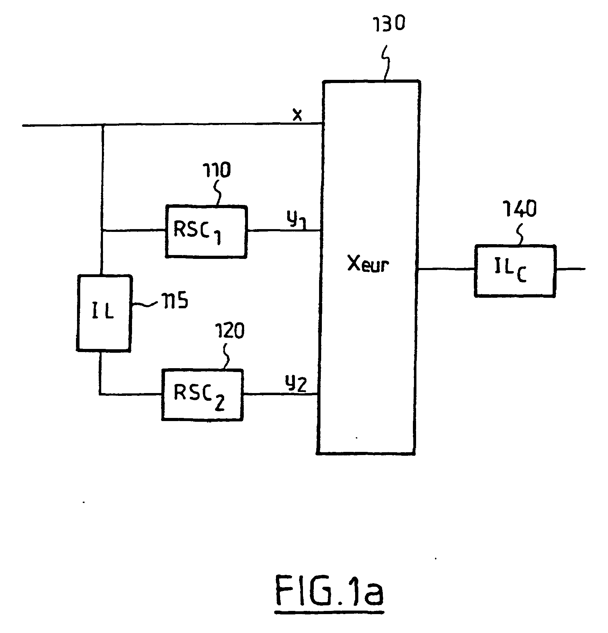

La Fig. 1a illustre de manière schématique un exemple de turbo-codeur. Le turbo-codeur représenté est un turbo-codeur parallèle de dimension 2. L'information x, sous la forme d'un bloc de données, est codée par un premier codeur élémentaire 110 pour fournir un première sortie y₁ et par un second codeur élémentaire 120, après avoir été entrelacée par l'entrelaceur 115, pour fournir une seconde sortie y₂. L'information systématique est multiplexée en 130 avec les informations codées y₁ et y₂ avant d'être entrelacée par un entrelaceur canal 140.

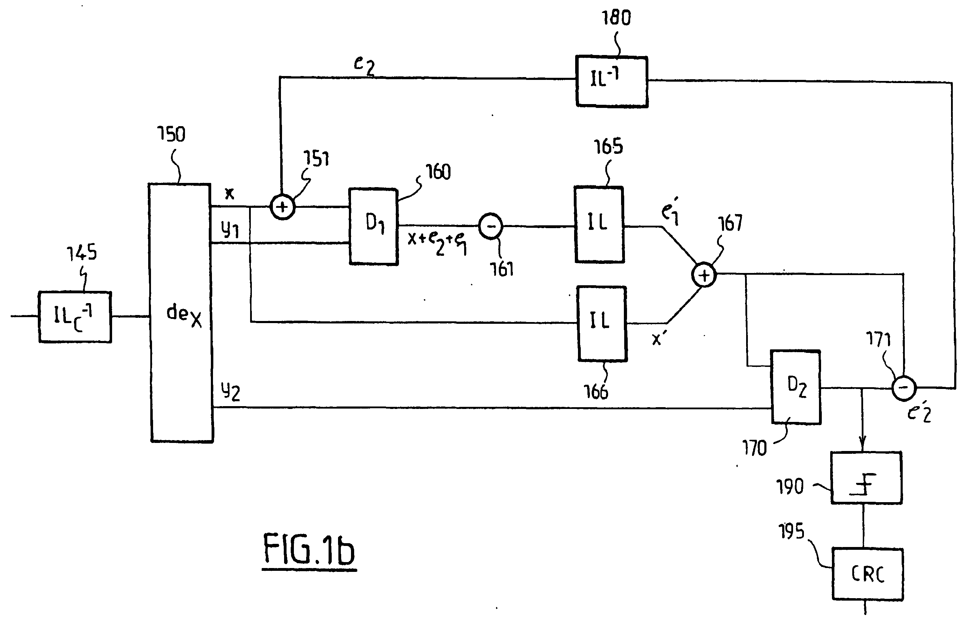

A la réception, l'information est décodée au moyen du turbo-décodeur représenté en Fig. 1b. Après désentrelacement dans le désentrelaceur canal 145, les informations x, y₁ et y₂ sont démultiplexées par le démultiplexeur 150. Les décodeurs élémentaires 160 et 170, par exemple du type Log MAP, correspondent respectivement aux codeurs élémentaires 110 et 120. Le décodeur 160, du type à entrée et à sortie pondérées, reçoit une information a priori sur x et l'information codée y₁ pour en déduire une information a posteriori sur x. La différence entre l'information a posteriori et l'information a priori est appelée information extrinsèque. L'information à priori sur x ainsi que l'information extrinsèque e₁ fournie par le premier décodeur sont entrelacées puis sommées pour fournir au décodeur 170 une nouvelle information a priori sur x (plus précisément sur x', version entrelacée de x). Le décodeur 170 estime à partir de cette information a priori et de l'information codée y₂, une information a posteriori sur x'. L'information intrinsèque e'₂ en est déduite par différence dans 171 avant d'être désentrelacée dans le désentrelaceur 180 puis est sommée en 151 à l'information systématique pour fournir une nouvelle information a priori de x au décodeur 160. Les étapes de décodage sont alors répétées et, ce, pour un nombre prédéterminé d'itérations *n*_{*itérations*}. Les valeurs souples en sortie du décodeur 170 sont soumises à un organe de décision 190 pour fournir des valeurs dures. Un contrôle de correction d'erreurs 195 opérant sur la sortie de 190 permet de déterminer si le bloc décodé est dépourvu d'erreurs et, dans l'affirmative, d'interrompre les itérations sans avoir à attendre le nombre prédéterminé *n*_{*itérations*}. Alternativement, pour décider de l'arrêt des itérations, le turbo-décodeur peut utilisé au lieu d'un CRC un autre critère d'arrêt sur les valeurs pondérées, tel que celui exposé, par exemple, dans l'article de J. Haguenauer et al. intitulé "Iterative decoding of binary block and convolutional codes", IEEE Transactions on Information Theory, vol. 42, pp.429-445, publié en Mars 1996 ou dans l'article de M. Moher intitulé "Decoding via cross entropy minimization", in Proc. IEEE Globecom Conf., Houston, TX, pp.809-813, publié en Decembre 1993.

Le principe du décodage itératif a été transposé à l'égalisation par C. Douillard et al. dans un article intitulé « Iterative Correction of Intersymbol Interference : Turbo-equalization » publié dans European Trans. Telecomm., Vol. 6, N°5, Sept./Oct 1995, pages 507-511. Cette méthode d'égalisation itérative, encore appelée turbo-égalisation part du principe qu'un canal affecté d'interférence inter-symbole (ISI) peut être considéré comme équivalent à un codeur convolutif et par conséquent la concaténation d'un codeur canal, d'un entrelaceur et d'un canal de transmission peut être elle même considérée comme l'équivalent d'un turbo-codeur.

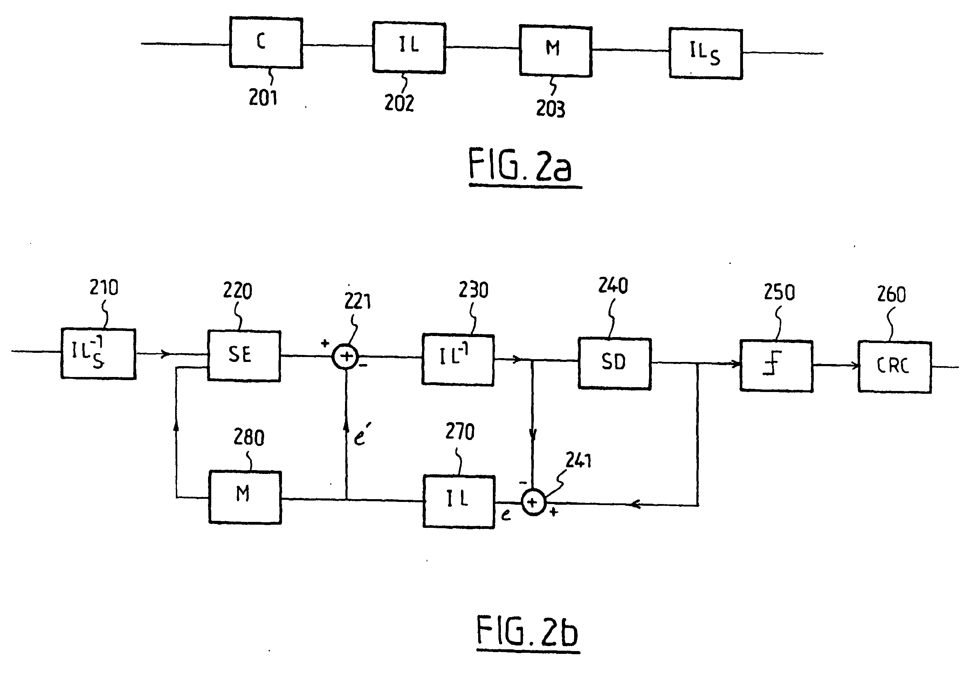

La Fig. 2b illustre de manière schématique la structure d'un turbo-égaliseur. On supposera que les données ont, du côté de l'émetteur représenté en Fig. 2a fait l'objet d'un codage canal dans un codeur 201 avant d'être entrelacées dans un entrelaceur 202 et modulées par un modulateur M-aire à symbole 203. Les données sont transmises sous la forme d'un bloc de symboles entrelacés par l'entrelaceur canal 204. Le turbo-égaliseur comprend tout d'abord un désentrelaceur canal 210 suivi d'un égaliseur à sortie pondérée de type Log-MAP fournissant des valeurs souples de données codées. Ces données sont désentrelacées dans le désentrelaceur 230 avant d'être décodées par un décodeur 240 de type Log-MAP à sortie pondérée. Les valeurs souples issues du décodeur 240 font soumises à un organe de décision 250 fournissant les valeurs dures correspondantes. Les valeurs pondérées en entrée du décodeur 240 sont soustraites à celles de sortie pour fournir une information extrinsèque e. Après entrelacement, l'information extrinsèque est d'une part soustraite à la sortie de l'égaliseur 220 et d'autre part remodulée avant d'être transmise à l'égaliseur. A partir des symboles reçus et de l'information extrinsèque remodulée, l'égaliseur 220 procède à une nouvelle estimation a priori. Le turbo-égaliseur procède ainsi à un nombre prédéterminé d'itérations sur un bloc de symboles. Un contrôle de correction d'erreurs 260 en sortie de 250 diagnostique la présence ou l'absence d'erreurs, le processus d'itération est interrompu sans les itérations sans avoir à attendre le nombre prédéterminé *n*_{*itérations*}. Le critère d'arrêt peut alternativement porter sur les valeurs pondérées comme on l'a vu plus haut.

Notons sur le plan de la réalisation qu'aussi bien pour le turbo-codage que pour la turbo-égalisation, les itérations peuvent être effectuées l'une après l'autre au sein d'un même processeur ou dans des circuits dédiés arrangés en pipeline, chacun prenant en charge une itération de rang déterminé.

Dans le cas du turbo-codage comme celui de la turbo-égalisation, les performances en terme de taux d'erreurs binaires (TEB) ou de taux d'erreurs paquets (TEP) sont d'autant meilleures que la longueur de la taille *N* de l'entrelaceur interne (IL) est grande. En effet, l'augmentation de la taille de l'entrelaceur interne, c'est-à-dire de la taille du bloc sur lequel est effectué l'entrelacement, améliore à la fois la distribution de poids de Hamming du turbo-code et l'efficacité du décodage itératif. Le gain d'entrelacement varie selon le type de turbo-code. On désignera par la suite sous le terme de «performances» indifféremment le TEB ou le TEP sur les données décodées.

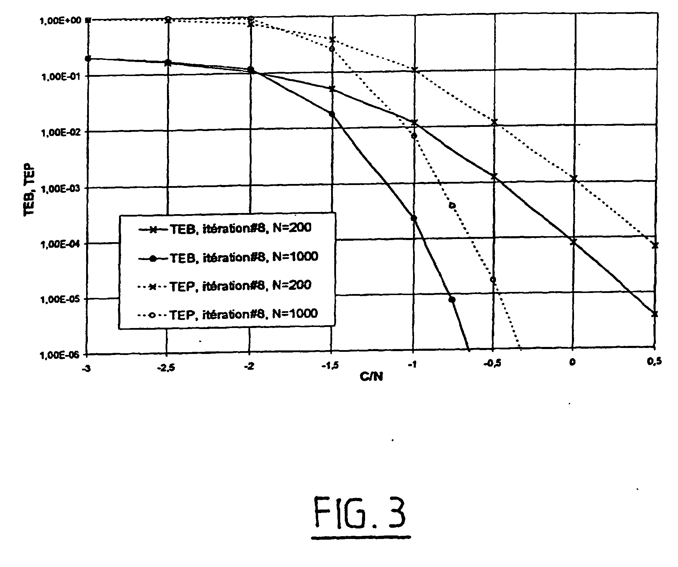

La Fig. 3 montre, à titre d'exemple, le gain d'entrelacement pour le turbo-codeur de la Fig. 1a, dont les codeurs élémentaires sont des codeurs RSC (Recursive Systematic Convolutional) de polynômes (13,15)_{oct}, lorsque la taille *N* du bloc passe de 200 à 1000.

Lorsque le temps de latence du récepteur, défini comme le temps au bout duquel un bloc de données ou de symboles reçus est effectivement disponible sous forme décodée, est un paramètre critique de l'application, il est connu de l'état de la technique d'utiliser des valeurs faibles de *N* .

Le temps de latence au niveau du récepteur peut s'écrire en effet: ${T}_{latence} = {T}_{rec} + \frac{N}{{D}_{d}} ⋅ {n}_{itérations}$
où *D*_{*d*} est le débit de décodage par itération et *T*_{*rec*} est la durée nécessaire à l'obtention des données d'un bloc sous forme désentrelacée.

Une diminution du temps de latence peut être obtenu en réduisant la taille des blocs, au prix toutefois, comme on l'a vu en Fig. 3, d'une diminution corrélative des performances du système. Un problème à la base de l'invention est de déterminer, sans dégradation des performances, une taille N de bloc permettant d'obtenir un temps de latence plus faible que dans l'état de la technique.

Lorsque le décodage itératif est pris en charge par un processeur rapide, la ressource critique n'est plus le temps de latence mais plutôt l'énergie dépensée pour effectuer le calcul, elle-même dépendant également du nombre d'opérations intervenant dans le décodage.

Le problème général à la base de l'invention est de déterminer, sans dégradation des performances, une taille *N* de bloc permettant une dépense de ressource plus faible que dans l'état de la technique.

La solution apportée par l'invention est définie par un procédé d'optimisation de taille de blocs de données codées destiné à être soumis à un décodage itératif, un taux maximal d'erreurs en sortie du décodage itératif étant préalablement fixé, le procédé recherchant parmi une pluralité de tailles de bloc sous-multiples de la taille courante de bloc d'un facteur entier supérieur ou égal à 1 et une pluralité d'entiers donnant le nombre maximal d'itérations que peut effectuer ledit décodage itératif sur un bloc, une taille sous-multiple et un nombre maximal d'itérations tels qu'ils soient compatibles avec ledit taux maximal d'erreurs et tels qu'un nombre moyen d'itérations qu'effectuerait le décodage itératif sur un bloc de taille sous-multiple soit le plus faible possible.

Avantageusement, pour une taille sous-multiple d'un facteur *k* donné et un nombre maximal d'itérations donné, ledit nombre moyen d'itérations est déterminé en fonction du rapport signal à bruit comme la valeur moyenne du nombre d'itérations qu'effectuerait le décodage itératif pour chaque bloc d'une succession de blocs de taille sous-multiple, les itérations étant arrêtées si le bloc de taille sous-multiple vérifie un critère de fiabilité prédéterminé ou si le nombre d'itérations pour ce bloc atteint ledit nombre maximal d'itérations donné.

Les nombres moyens d'itérations pour différentes tailles sous-multiples, différents nombres maximaux d'itérations et différents rapports signal à bruit sont de préférence stockées dans une table qui peut être mise à jour au fur et à mesure du décodage itératif. Les nombres moyens d'itérations seront avantageusement obtenus par interpolation à partir des valeurs disponibles dans la table.

Ladite recherche pourra être limitée aux entiers qui ont une valeur supérieure à une valeur prédéterminée.

Selon un mode de réalisation, on détermine, préalablement à la recherche, le nombre maximal d'itérations pour un bloc de taille courante, compatible avec un temps de décodage maximal prédéterminé et que la recherche parmi ladite pluralité de tailles de bloc sous-multiples et ladite pluralité d'entiers est limitée aux valeurs telles que le nombre moyen d'itérations qu'effectuerait le décodage itératif sur un bloc de taille sous-multiple est inférieur audit nombre maximal d'itérations.

L'invention est également définie par un procédé de décodage itératif de blocs de données codés, les blocs ayant une taille initiale, ledit procédé déterminant une taille optimale de bloc et un nombre maximal d'itérations associé à cette taille par le procédé d'optimisation exposé ci-dessus. Les données d'un bloc de taille initiale ayant été codées comme une séquence de sous-blocs de taille optimale, les sous-blocs sont décodés, un par un, par une successions d'itérations du décodage itératif, les itérations étant arrêtées pour un sous-bloc si un critère de fiabilité prédéterminé est satisfait ou si le nombre d'itérations atteint ledit nombre maximal d'itérations associée à ladite taille optimale.

L'invention est encore définie par un procédé de décodage itératif de blocs de données codés, les blocs ayant une taille initiale, dans lequel on détermine une taille optimale de bloc et un nombre maximal d'itérations associé à cette taille par le procédé d'optimisation exposé ci-dessus. Les données d'un bloc de taille initiale ayant été codées comme une séquence de sous-blocs de taille optimale, les sous-blocs sont décodés en effectuant successivement sur chaque sous-bloc une itération du décodage itératif, une itération n'étant pas effectuée pour un sous-bloc si un critère de fiabilité prédéterminé est satisfait ou si le nombre d'itérations atteint le nombre maximal d'itérations associé à ladite taille optimale.

L'invention concerne un dispositif de décodage itératif de blocs de données codées par un turbo-codeur comportant des moyens pour mettre en oeuvre le procédé d'optimisation défini plus haut, lesdits moyens fournissant une taille de bloc optimale et un nombre maximal d'itérations par bloc de taille optimale, le dispositif comprenant en outre des moyens pour transmettre au turbo-codeur une information de taille de bloc optimale.

L'invention concerne aussi un système de codage/décodage comprenant un turbo-codeur adapté à coder des blocs de données et un dispositif de décodage itératif défini plus haut, adapté à décoder les blocs de données codées par le turbo-codeur, ce dernier comprenant des moyens pour recevoir ladite information de taille de bloc optimale et pour modifier la taille d'au moins un entrelaceur interne en fonction de ladite information reçue.

L'invention concerne encore un dispositif de codage de bloc de données, comportant des moyens pour mettre en oeuvre le procédé d'optimisation défini plus hait, lesdits moyens fournissant une taille de bloc optimale, le dispositif comprenant en outre des moyens pour modifier adaptativement la taille des blocs de données codées en fonction de ladite taille de bloc optimale.

L'invention concerne enfin un dispositif de turbo-égalisation de blocs de données codées par un codeur et modulées, comportant des moyens pour mettre en oeuvre le procédé d'optimisation défini plus haut, lesdits moyens fournissant une taille de bloc optimale, ledit dispositif comprenant en outre des moyens pour transmettre au codeur une information de taille de bloc optimale.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1a illustre schématiquement un exemple de turbo-codeur connu de l'état de la technique ;
la Fig. 1b illustre schématiquement un exemple de turbo-décodeur, de structure connue, adapté à décoder des données codées par le turbo-codeur de la Fig. 1a ;
la Fig. 2a illustre schématiquement un exemple d'émetteur connu de l'état de la technique ;
la Fig. 2b illustre schématiquement un exemple de turbo-égaliseur connu de l'état de la technique ;
la Fig. 3 représente le gain d'entrelacement du turbo-codeur de la Fig. 1a en passant d'une première taille de bloc à une seconde taille de bloc ;
la Fig. 4 représente le nombre moyen d'itérations du turbo-décodeur de la Fig. 1b pour un nombre maximal d'itérations donné et lorsqu'un critère d'arrêt parfait est utilisé ;
la Fig. 5 représente un histogramme du nombre d'itérations nécessaires pour satisfaire à un critère d'arrêt parfait ;
la Fig. 6 illustre l'avantage du moyennage du nombre d'itérations résultant de la présente invention ;
la Fig. 7 représente un organigramme de la méthode de détermination de la taille de bloc optimale selon un premier mode de réalisation de l'invention.

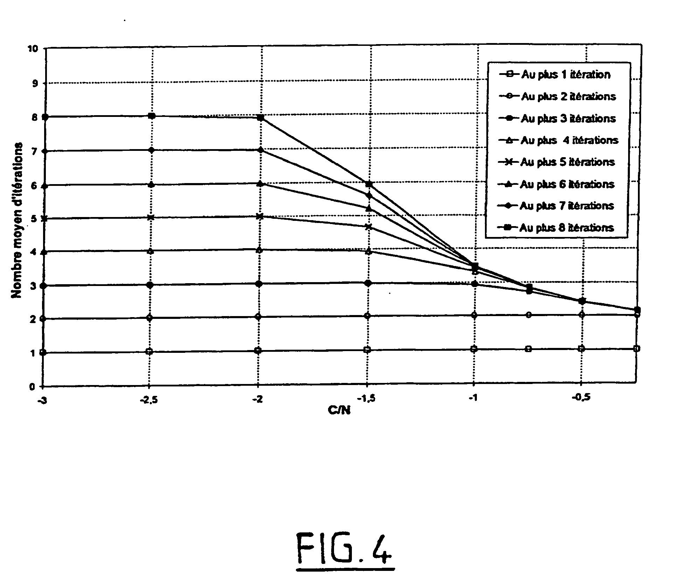

L'idée générale à la base de l'invention est de mettre à profit le fait que, dans un décodeur itératif, pour un nombre d'itérations *n*_{*itérations*} prédéterminé, que nous appellerons nombre de consigne, le bloc peut être entièrement décodé avant la dernière itération prévue. Par exemple, si le critère d'arrêt des itérations est un critère parfait (TEB nul, c'est à dire absence complète d'erreurs dans le bloc, le nombre moyen d'itérations, ${\overline{n}}_{itérations} ,$ est souvent inférieur au nombre de consigne, comme on peut s'en rendre compte sur la Fig. 4. Cette figure représente l'évolution de ${\overline{n}}_{itérations}$ en fonction du rapport signal à bruit pour différentes valeurs de *n*_{*itérations*}. On voit que, pour un nombre *n*_{*itérations*} donné, le nombre moyen d'itérations n'atteint pas cette valeur et ce d'autant que le rapport signal à bruit est élevé. Bien entendu, en pratique, on ne dispose pas d'un critère d'arrêt parfait : on teste simplement l'absence d'erreurs par exemple au moyen d'un CRC et l'on arrête les itérations dès que le CRC ne détecte plus d'erreurs. Les conclusions concernant l'évolution de ${\overline{n}}_{itérations}$ par rapport à *n*_{*itérations*} restent cependant valables.

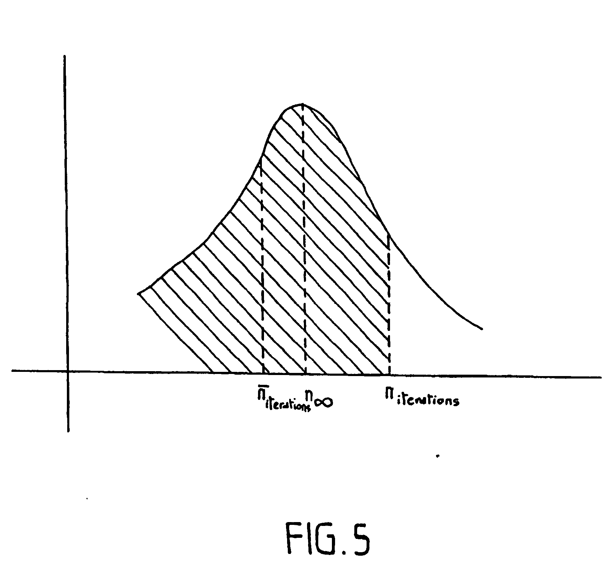

On a représenté schématiquement en Fig. 5 un histogramme du nombre d'itérations nécessaires à l'obtention d'un TEB (et donc d'un TEP) nul. Comme, en pratique, on ne peut effectuer un nombre infini d'itérations, l'on fixe, ainsi qu'on l'a vu plus haut, un nombre d'itérations de consigne *n*_{*itérations*} compatible avec le temps de latence et on en déduit la taille de l'entrelaceur selon (1). La moyenne ${\overline{n}}_{∞}$ de l'histogramme correspond à un nombre de consigne infini. Pour un nombre de consigne n_{itérations} donné, la valeur moyenne ${\overline{n}}_{itérations}$ est prise sur la zone hachurée de la courbe.

Supposons donné un temps de latence de consigne T et que l'on ait déterminé un couple de valeurs (*n*_{*itérations*}, *N*) satisfaisant à *T*_{*latence*}≤*T* où *T*_{*latence*} est donné par (1). Nous noterons par la suite *n*_{*itérations*} et *T*_{*latence*} respectivement ${n}_{itérations}^{( l )}$ et ${T}_{latence}^{( l )} .$

Supposons maintenant que la taille *N* du bloc, et donc celle de l'entrelaceur interne du turbo-codeur ou du turbo-égaliseur, soit divisée par un entier *k* non nul. Le temps de latence ${T}_{latence}^{( k )}$ au bout duquel les *k* blocs de taille réduite *N*/*k* sont décodés s'exprime alors comme : ${T}_{latence}^{( k )} = {T}_{rec}^{( k )} + {\sum }_{i = 1}^{k} \frac{N / k}{{D}_{d}} ⋅ {n}_{itérations} ( i ) = {T}_{rec}^{( k )} + \frac{N}{{D}_{d}} ⋅ {\overline{n}}_{itérations}^{( k )}$
où ${T}_{rec}^{( k )}$ est un temps de réception au bout duquel les *k* blocs de taille *N*/*k* sont disponibles, le cas échéant sous forme désentrelacée, au niveau du récepteur. En absence d'entrelacement canal, ce temps de réception vaut $\frac{N}{k . {D}_{u}} + {\sum }_{i = 2}^{k} δ {t}_{rec}^{( i )}$où $\frac{N}{k . {D}_{u}}$ est le temps de réception du 1^{er} bloc de taille *N*/*k* et $δ {t}_{rec}^{( i )}$ est le temps que doit attendre le récepteur entre la fin du décodage du (i-1)^{ème} bloc et la fin de la réception du i^{ème} bloc. Par conséquent, on a : $\frac{N}{k . {D}_{u}} \leq {T}_{rec}^{( k )} < \frac{N}{{D}_{u}} .$ En revanche, lorsqu'un entrelacement canal de taille *M*_{*k*} avec *M*_{*k*}*≥N*/*k* a été appliqué au niveau de l'émetteur on a: ${T}_{rec}^{( k )} = {M}_{k} / {D}_{u} + {\sum }_{i = 2}^{N / {M}_{k}} {δ}_{rec}^{( i )}$où ${δ}_{rec}^{( i )}$ est le temps d'attente entre la fin du désentrelacement du (i-1)^{ème} groupe de *k.M*_{*k*}/*N* blocs et leur décodage d'une part et la fin de la réception du i^{ème} groupe d'autre part. En pratique, on prendra *M*_{*k*}=*N* et donc ${T}_{rec}^{( k )} = {M}_{k} / {D}_{u} .$

*n*_{*itéralions*}(*i*) est le nombre d'itérations effectuées par le décodeur sur le i^{ème} bloc de taille *N*/*k* en utilisant un critère d'arrêt prédéterminé et pour un nombre d'itérations de consigne ${n}_{itérations}^{( k )}$ donné ;

${\overline{n}}_{itérations}^{( k )}$ itérations est le nombre moyen d'itérations, pris sur l'ensemble des *k* blocs. On notera que ${\overline{n}}_{itérations}^{( k )}$ dépend en général du nombre de consigne ${n}_{itérations}^{( k )}$ choisi pour la taille de bloc *N*/*k* ainsi que du rapport signal à bruit. On désignera par la suite (*N*/*k,* ${n}_{itérations}^{( k )}$) un turbo-code opérant sur des blocs de taille *N*/*k* et décodé au moyen d'au plus ${n}_{itérations}^{( k )}$ par bloc.

On notera d'abord qu'en général, la taille *M*_{*k*} de l'entrelacement canal décroît (au sens large) avec *k*, et donc que ${T}_{rec}^{( k )}$ est une fonction décroissante de *k* : ${T}_{rec}^{( k + 1 )} \leq {T}_{rec}^{( k )}$ qu'un entrelacement canal soit appliqué ou non.

On notera encore que le critère d'arrêt peut tolérer un taux d'erreurs résiduelles prédéterminé. On peut faire appel, comme évoqué plus haut, à un critère d'arrêt opérant sur (des) sortie(s) pondérée(s) ou une (des) information(s) extrinsèque(s) et déclencher l'arrêt des itérations lorsqu'un seuil de fiabilité prédéterminé est atteint. Dans tous les cas, le critère d'arrêt porte sur la fiabilité des blocs de données décodées et sera pour cette raison également nommé critère de fiabilité. Le critère d'arrêt utilisé est choisi identique pour toutes les valeurs de *k.*

L'invention repose sur le fait que, le processus de décodage itératif convergeant généralement avant d'atteindre le nombre maximal d'itérations de consigne, on peut trouver un entier *k*, un nombre de consigne ${n}_{itérations}^{( k )}$ tel que le nombre moyen d'itérations ${\overline{n}}_{itérations}^{( k )}$ soit tel que ${\overline{n}}_{itérations}^{( k )} < {n}_{itérations}^{( l )}$ et donc a fortiori ${T}_{latence}^{( k )} < {T}_{latence}^{( l )} .$

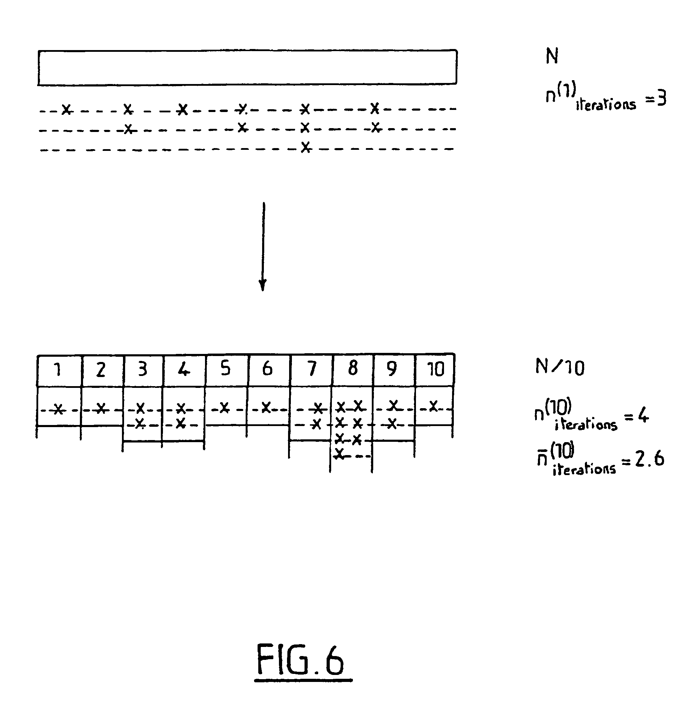

La comparaison entre les deux situations est illustrée en Fig. 6. Une itération est représentée par un trait horizontal s'étendant sur la longueur du bloc. Le trait est en pointillés s'il reste des erreurs après l'itération et en trait plein dans le cas contraire. L'emplacement des erreurs est indiqué symboliquement par des croix. La partie haute de la figure illustre le processus de décodage itératif sur un bloc de taille *N* et pour un nombre de consigne ${n}_{itérations}^{( l )} = 3$ d'itérations, vérifiant la contrainte de latence 3*N*/*D*_{*d*}*≤T* (on suppose pour simplifier qu'il n'y a pas d'entrelacement de canal et que le temps de réception est nul). Le processus itératif n'a pas convergé au bout de la 3^{ième} itération et le bloc décodé présente une erreur résiduelle. La partie basse de la figure illustre la situation lorsque la taille du bloc est divisé par 10. Le nombre de consigne ${n}_{itérations}^{( 10 )}$ a été choisi égal à 4. On voit que pour la grande majorité des blocs, le processus itératif converge avant quatre et même avant trois itérations. Dans cet exemple, seul le bloc n°8 présente encore une erreur au bout de la 4^{ième} itération. A taux d'erreurs identique, on passe ainsi d'un temps de latence 3*N*/*D*_{*d*} à un temps de latence de 2.6*N*/*D*_{*d*}.

De manière générale, le choix d'un facteur *k* et d'un nombre d'itérations ${n}_{itérations}^{( k )}$ permet de passer d'un temps de latence ${T}_{latence}^{( l )}$ à un temps de latence ${T}_{latence}^{( k )}$ plus faible tout en respectant une contrainte de performances donnée. On recherche alors parmi les valeurs de *k* et ${n}_{itérations}^{( k )} ,$ le couple de valeurs qui permet d'obtenir le temps de latence ${T}_{latence}^{( k )}$ le plus faible possible. La valeur de *k* retenue doit être suffisanunent grande pour mettre le moyennage des temps de latence sur *k* blocs de taille réduite *N*/*k*.

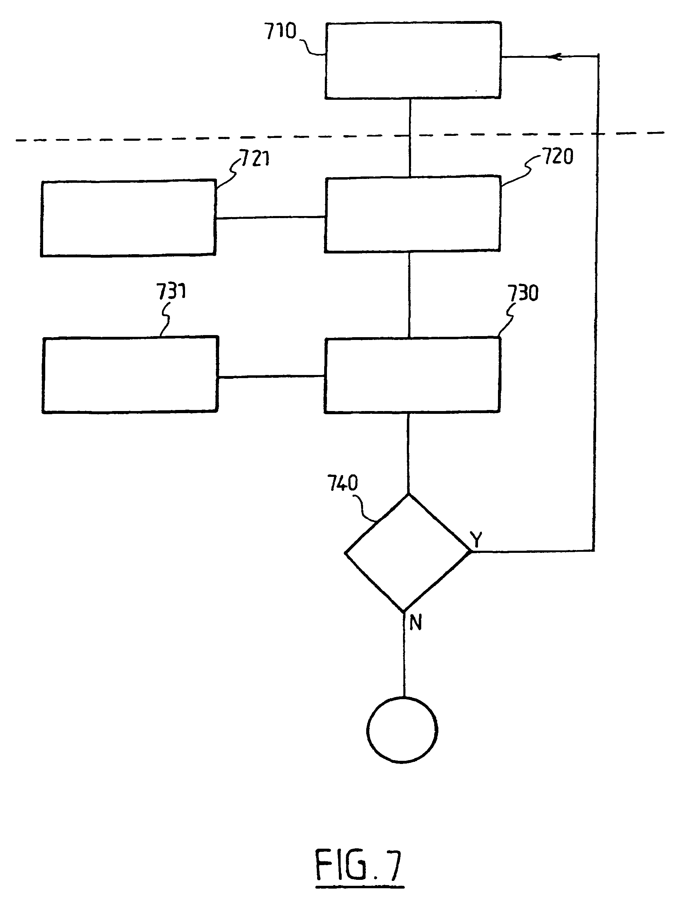

La Fig. 7 donne schématiquement un organigramme de la méthode d'optimisation de la taille de bloc sous contrainte de performances selon un premier mode de réalisation de l'invention. L'émission représentée en 710 utilise une longueur d'entrelacement interne et une taille de bloc *N*. A la réception, on détermine en 720 à partir de *N* et d'une estimation 721 du temps de latence maximal *T*, le nombre maximal d'itérations ${n}_{itérations}^{( l )}$ grâce à l'équation (1). Dans un seconde étape 730, le système sélectionne ensuite au sein d'une table 731, les valeurs de *k* (*k*≥1 et diviseur de *N*) et ${n}_{itérations}^{( k )}$ compatibles avec le niveau de performances (TEB, TEP) requis, compte tenu du rapport signal à bruit. Selon une variante de l'invention, lorsque l'on utilise un entrelacement canal de taille fixe ( ${T}_{rec}^{( k )}$ est donc une constante), on limite préalablement la recherche aux valeurs *k* et ${n}_{itérations}^{( k )}$ telles que ${\overline{n}}_{itérations}^{( k )} < {n}_{itérations}^{( l )} .$ On détermine ensuite en 730, parmi les valeurs sélectionnées, le couple (*k*, ${n}_{itérations}^{( k )}$) donnant le temps de latence ${T}_{latence}^{( k )}$ le plus faible.

On teste en 740 si la valeur de *k* retenue est supérieure à une valeur *k*_{*min*} nécessaire au moyennage du temps de latence. Dans l'affirmative, la valeur de *k* et donc la nouvelle taille de bloc *N*/*k* est transmise à l'émetteur par une voie de retour. Le turbo-codeur adapte alors la taille des blocs et la taille de son ou ses entrelaceurs internes en fonction de cette nouvelle valeur. Dans la négative, le processus d'optimisation est terminé et la taille de bloc reste inchangée.

Alternativement au mode de réalisation représenté, le test 740 n'est pas effectué et la recherche dans la table 731 est limitée aux valeurs de *k* supérieures à *k*_{*min*}.

La table 731 peut être élaborée au préalable ou bien a posteriori à partir des performances obtenues et des nombres d'itérations effectifs. Elle peuvent également être élaborées au préalable et complétées au fur et à mesure de l'utilisation du système. Les valeurs indisponibles dans les tables peuvent être calculées par interpolation à partir des valeurs existantes.

Selon un second mode de réalisation de l'invention, le processus d'optimisation de taille de bloc est effectué au niveau de l'émetteur et le système de comporte pas de voie de retour entre le récepteur et l'émetteur. La taille de bloc est modifiée au niveau de l'émetteur et le nombre maximal d'itérations par bloc est réduit le plus possible au niveau du récepteur, sous contrainte d'un taux d'erreurs maximal en sortie du décodage itératif. On obtient ainsi un nombre moyen d'itérations et donc un temps de latence du récepteur réduit au maximum.

Quel que soit le mode de réalisation, lorsque la taille *N* du bloc a été divisée par un facteur *k*, le processus itératif peut être effectué de deux manières possibles.

Selon une première variante, on effectue la 1^{ère} itération de décodage pour chacun des *k* blocs, puis on effectue la 2^{ème} itération de décodage pour les blocs présentant des erreurs résiduelles après la 1^{ère} itération et ainsi de suite jusqu'à ce que la ressource disponible ou le temps imparti pour le décodage des *k* blocs soit épuisé. A chaque passe on identifie grâce au critère d'arrêt les blocs présentant des erreurs résiduelles. De cette façon, on est sûr d'utiliser la ressource disponible ou la latence impartie de façon optimale et on évite de "s'attarder" trop longtemps sur le décodage d'un bloc, ce qui pourrait être préjudiciable aux blocs suivants si *k* n'est pas assez grand pour assurer un moyennage suffisant du nombre d'itérations.

Dans le cas de l'exemple de la Fig. 6, la mise en oeuvre de cette variante se traduirait de la façon suivante :
1- Itération#1 pour les blocs 1 à 10
2- Itération#2 pour les blocs 1 à 10 -> blocs 1, 2, 5, 6, 10 corrects
3- Itération#3 pour les blocs 3, 4, 7, 8, 9 -> blocs 3, 4, 7, 9 corrects
4- Itération#4 pour le bloc 8

Cette première variante de décodage est avantageuse lorsque la durée d'entrelacement de canal ${T}_{rec}^{( k )} = {M}_{k} / {D}_{u}$ est fixée ou lorsque *k* est petit. En effet, dans le premier cas, on doit attendre de toutes façons le temps *M*_{*k*}/*D*_{*u*} avant de pouvoir décoder un bloc et, dans le second cas, elle permet de remédier à un défaut éventuel de moyennage.

Selon une seconde variante, on décode successivement chacun des *k*=10 blocs. Au maximum ${n}_{itérations}^{( 10 )} = 4$ itérations de décodage sont effectuées successivement sur chaque bloc en utilisant le critère d'arrêt pour atteindre ${\overline{n}}_{itérations}^{( 10 )} = 2.6$ itérations par bloc en moyenne sur l'ensemble des 10 blocs.

Dans le cas de l'exemple de la Fig. 6, la mise en oeuvre de cette variante se traduirait de la façon suivante :
1. itérations #1 à #2 pour le bloc 1
2. itérations #1 à #2 pour le bloc 2
3. itérations #1 à #3 pour le bloc 3
4. itérations #1 à #3 pour le bloc 4
5. itérations #1 à #2 pour le bloc 5
6. itérations #1 à #2 pour le bloc 6
7. itérations #1 à #3 pour le bloc 7
8. itérations #1 à # ${n}_{itérations}^{( 10 )} = 4$ pour le bloc 8
9. itérations #1 à #3 pour le bloc 9
10. itérations #1 à #2 pour le bloc 10

Cette deuxième variante est avantageuse lorsque la durée d'entrelacement de canal ${T}_{rec}^{( k )} = {M}_{k} / {D}_{u}$ n'est pas fixée ou lorsque *k* est grand. En effet, si la durée *M*_{*k*}/*D*_{*u*} n'est pas fixée, elle peut être réduite, éventuellement au prix d'une perte de performances, à une valeur correspondant à un entrelacement sur *k'<k* blocs de taille *k*/*N* consécutifs. Il en résulte que le temps de latence ${T}_{latence}^{( k )}$ donné par (2) peut être également réduit.

Il est essentiel de noter que le temps de latence maximal dont il a été essentiellement question jusqu'ici n'est qu'un exemple de ressource disponible pour effectuer le décodage itératif. Par ressource, on pourra également entendre l'énergie dépensée par un processeur, fonction elle-même du nombre moyen d'itérations. De manière plus générale, on entendra par ressource disponible une grandeur physique additive susceptible d'être dépensée par le décodage itératif.

Bien que la description de l'invention ait été essentiellement illustrée comme un processus d'optimisation de taille de blocs turbo-codés sous contrainte de performances, elle s'applique également, de manière similaire, à un processus d'optimisation de la taille de blocs turbo-égalisés sous contrainte de performances, que cette optimisation soit effectuée au niveau du turbo-égaliseur (premier mode de réalisation) ou au niveau de l'émetteur (second mode de réalisation).

## Revendications

1. Procédé d'optimisation de taille de blocs de données codées destinés à être soumis à un décodage itératif, **caractérisé en ce que**, un taux maximal d'erreurs en sortie du décodage itératif étant préalablement fixé, le procédé recherche parmi une pluralité de tailles (*N*/*k*) de bloc sous-multiples de la taille courante de bloc d'un facteur (*k*) entier supérieur ou égal à 1 et une pluralité d'entiers donnant le nombre maximal d'itérations ( ${n}_{itérations}^{( k )}$) que peut effectuer ledit décodage itératif sur un bloc, une taille sous-multiple et un nombre maximal d'itérations tels qu'ils soient compatibles avec ledit taux maximal d'erreurs et tels qu'un nombre moyen d'itérations ( ${\overline{n}}_{itérations}^{( k )}$) qu'effectuerait le décodage itératif sur un bloc de taille sous-multiple soit le plus faible possible.

2. Procédé d'optimisation selon la revendication 1, **caractérisé en ce que**, pour une taille sous-multiple d'un facteur *k* donné et un nombre maximal d'itérations ( ${n}_{itérations}^{( k )}$) donné, ledit nombre moyen d'itérations ( ${\overline{n}}_{itérations}^{( k )}$) est déterminé en fonction du rapport signal à bruit comme la valeur moyenne du nombre d'itérations qu'effectuerait le décodage itératif pour chaque bloc d'une succession de blocs de taille sous-multiple, les itérations étant arrêtées si le bloc de taille sous-multiple vérifie un critère de fiabilité prédéterminé ou si le nombre d'itérations pour ce bloc atteint ledit nombre maximal d'itérations donné.

3. Procédé d'optimisation selon la revendication 1 ou 2, **caractérisé en ce que** lesdits nombres moyens d'itérations pour différentes tailles sous-multiples, différents nombres maximaux d'itérations et différents rapports signal à bruit sont stockées dans une table.

4. Procédé d'optimisation selon la revendication 3, **caractérisé en ce que** la table est mise à jour au fur et à mesure du décodage itératif.

5. Procédé d'optimisation selon la revendication 3 ou 4, **caractérisé en ce que** les nombres moyens d'itérations sont obtenus par interpolation à partir des valeurs disponibles dans la table.

6. Procédé d'optimisation selon l'une des revendications précédentes, **caractérisé en ce que** la recherche est limitée aux entiers qui ont une valeur supérieure à une valeur (*k*_{*min*}) prédéterminée.

7. Procédé d'optimisation selon l'une des revendications précédentes, **caractérisé en ce qu'**il détermine, préalablement à la recherche, le nombre maximal d'itérations ( ${n}_{itérations}^{( l )}$) pour un bloc de taille courante, compatible avec un temps de décodage maximal prédéterminé et que la recherche parmi ladite pluralité de tailles (*N*/*k*) de bloc sous-multiples et ladite pluralité d'entiers est limitée aux valeurs telles que le nombre moyen d'itérations (${\overline{n}}_{itérations}^{( k )}$) qu'effectuerait le décodage itératif sur un bloc de taille sous-multiple est inférieur audit nombre maximal d'itérations ( ${n}_{itérations}^{( l )}$).

8. Procédé de décodage itératif de blocs de données codés, les blocs ayant une taille initiale, **caractérisé en ce que** l'il détermine une taille optimale de bloc et un nombre maximal d'itérations associé à cette taille par le procédé d'optimisation selon une des revendications précédentes et que les données d'un bloc de taille initiale ayant été codées comme une séquence de sous-blocs de taille optimale, les sous-blocs sont décodés, un par un, par une successions d'itérations du décodage itératif, les itérations étant arrêtées pour un sous-bloc si un critère de fiabilité prédéterminé est satisfait ou si le nombre d'itérations atteint ledit nombre maximal d'itérations associée à ladite taille optimale.

9. Procédé de décodage itératif de blocs de données codés, les blocs ayant une taille initiale, **caractérisé en ce que** l'il détermine une taille optimale de bloc et un nombre maximal d'itérations associé à cette taille par le procédé d'optimisation selon une des revendications précédentes et que les données d'un bloc de taille initiale ayant été codées comme une séquence de sous-blocs de taille optimale, les sous-blocs sont décodés en effectuant successivement sur chaque sous-bloc une itération du décodage itératif, une itération n'étant pas effectuée pour un sous-bloc si un critère de fiabilité prédéterminé est satisfait ou si le nombre d'itérations atteint le nombre maximal d'itérations associé à ladite taille optimale.

10. Dispositif de décodage itératif de blocs de données codées par un turbo-codeur, **caractérisé en ce qu'**il comporte des moyens pour mettre en oeuvre le procédé d'optimisation selon l'une des revendications 1 à 7, lesdits moyens fournissant une taille de bloc optimale et un nombre maximal d'itérations par bloc de taille optimale, le dispositif comprenant en outre des moyens pour transmettre au turbo-codeur une information de taille de bloc optimale.

11. Système de codage/décodage comprenant un turbo-codeur adapté à coder des blocs de données et un dispositif de décodage itératif selon la revendication 10 adapté à décoder les blocs de données codées par le turbo-codeur, ce dernier comprenant des moyens pour recevoir ladite information de taille de bloc optimale et pour modifier la taille d'au moins un entrelaceur interne en fonction de ladite information reçue.

12. Dispositif de codage de bloc de données, **caractérisé en ce qu'**il comporte des moyens pour mettre en oeuvre le procédé d'optimisation selon l'une des revendications 1 à 7, lesdits moyens fournissant une taille de bloc optimale, le dispositif comprenant en outre des moyens pour modifier adaptativement la taille des blocs de données codées en fonction de ladite taille de bloc optimale.

13. Dispositif de turbo-égalisation de blocs de données codées par un codeur et modulées, **caractérisé en ce qu'**il comporte des moyens pour mettre en oeuvre le procédé d'optimisation selon l'une des revendications 1 à 7, lesdits moyens fournissant une taille de bloc optimale, le dispositif comprenant en outre des moyens pour transmettre au codeur une information de taille de bloc optimale.

## Claims

1. Method of optimising the size of coded data blocks intended to be subjected to an iterative decoding, **characterised in that**, a maximum rate of errors at the output of the iterative decoding being previously fixed, the method searches, from among a plurality of sub-multiple block sizes (*N*/*k*) of the current block size of an integer factor (*k*) greater than or equal to 1 and from among a plurality of integers which give the maximum number of iterations ( ${n}_{itérations}^{( k )}$) which said iterative decoding can effect on a block, for a sub-multiple size and a maximum number of iterations such that they are compatible with said maximum rate of errors, and such that a mean number of iterations ( ${n}_{itérations}^{( l )}$), which the iterative decoding would effect on a block of sub-multiple size, is the lowest possible.

2. Method of optimisation according to claim 1, **characterised in that**, for a sub-multiple size of a given factor *k* and a given maximum number of iterations ( ${n}_{itérations}^{( k )}$), said mean number of iterations ( ${\overline{n}}_{itérations}^{( k )}$) is determined as a function of the signal to noise ratio as the mean value of the number of iterations which the iterative decoding would effect for each block of a succession of blocks of sub-multiple size, the iterations being stopped if the block of sub-multiple size verifies a predetermined reliability criterion or if the number of iterations for this block reaches said given maximum number of iterations.

3. Method of optimisation according to claim 1 or 2, **characterised in that** said mean numbers of iterations for various sub-multiple sizes, various maximum numbers of iterations and various signal to noise ratios are stored in a table.

4. Method of optimisation according to claim 3, **characterised in that** the table is used progressively during the iterative decoding.

5. Method of optimisation according to claim 3 or 4, **characterised in that** the mean numbers of iterations are obtained by interpolation from the values available in the table.

6. Method of optimisation according to one of the preceding claims, **characterised in that** the search is limited to the integers which have a value greater than a predetermined value *(k*_{*min*}*).*

7. Method of optimisation according to one of the preceding claims, **characterised in that** it determines, prior to the search, the maximum number of iterations ( ${n}_{itérations}^{( l )}$) for a block of current size, compatible with a predetermined maximum decoding time, and **in that** the search from among said plurality of sizes (*N*/*k*) of sub-multiple blocks and said plurality of integers is limited to the values such that the mean number of iterations ( ${\overline{n}}_{itérations}^{( k )}$), which the iterative decoding would effect on a block of sub-multiple size, is less than said maximum number of iterations ( ${n}_{itérations}^{( l )}$)

8. Method of iteratively decoding blocks of coded data, the blocks having an initial size, **characterised in that** it determines an optimum size of block and a maximum number of iterations associated with this size by the method of optimisation according to one of the preceding claims, and **in that**, the data of a block of initial size having been coded as a sequence of sub-blocks of optimum size, the sub-blocks are decoded, one by one, by a succession of iterations of the iterative decoding, the iterations being stopped for a sub-block if a predetermined reliability criterion is satisfied or if the number of iterations reaches said maximum number of iterations associated with said optimum size.

9. Method of iteratively decoding blocks of coded data, the blocks having an initial size, **characterised in that** it determines an optimum size of block and a maximum number of iterations associated with this size by the method of optimisation according to one of the preceding claims, and **in that**, the data of a block of initial size having been coded as a sequence of sub-blocks of optimum size, the sub-blocks are decoded by successively effecting, on each sub-block, an iteration of the iterative decoding, an iteration not being effected for a sub-block if the predetermined reliability criterion is satisfied or if the number of iterations reaches the maximum number of iterations associated with said optimum size.

10. Device for the iterative decoding of coded data blocks by a turbo-coder, **characterised in that** it includes means for using the method of optimisation according to one of claims 1 to 7, said means providing an optimum size of block and a maximum number of iterations per block of optimum size, the device also comprising means for transmitting to the turbo-coder information concerning the optimum block size.

11. Coding/decoding system comprising a turbo-coder adapted to code blocks of data and a device for iterative decoding, according to claim 10, adapted to decode the data blocks coded by the turbo-coder, said turbo-coder comprising means for receiving said information concerning the optimum block size and for modifying the size of at least one internal interleaver in dependence on said received information.

12. Device for coding data blocks, **characterised in that** it includes means for using the method of optimisation according to one of claims 1 to 7, said means providing an optimum block size, the device additionally comprising means for adaptively modifying the size of the coded data blocks in dependence on said optimum block size.

13. Device for the turbo-equalisation of blocks of data, coded by a coder and modulated, **characterised in that** it includes means for using the method of optimisation according to one of claims 1 to 7, said means providing an optimum block size, the device additionally comprising means for transmitting to the coder information concerning the optimum block size.

## Patentansprüche

1. Verfahren zur Optimierung der Größe von codierten Datenblöcken, die dazu bestimmt sind, einer iterativen Decodierung unterzogen zu werden, **dadurch gekennzeichnet, dass** das Verfahren, bei welchem im Voraus eine maximale Fehlerrate am Ende der iterativen Decodierung festgelegt wird, unter einer Vielzahl von Blockgrößen (N/k), die Teilgrößen mit einem Faktor (k), der eine ganze Zahl größer oder gleich 1 ist, der aktuellen Blockgröße sind, und unter einer Vielzahl von ganzen Zahlen, die die maximale Anzahl von Iterationen (${n}_{Iterationen}^{( k )}$) angeben, die die iterative Decodierung an einem Block durchführen kann, eine Größe einer Teilgröße und eine maximale Anzahl von Iterationen sucht, so dass sie mit der maximalen Fehlerrate vereinbar sind und eine durchschnittliche Anzahl von Iterationen (${n}_{Iterationen}^{( k )}$), die die iterative Decodierung an einem Block mit der Größe der Teilgröße durchführt, möglichst klein ist

2. Optimierungsverfahren nach Anspruch 1, **dadurch gekennzeichnet, dass** für eine Größe der Teilgröße mit dem gegebenen Faktor k und eine gegebene maximale Anzahl von Iterationen ( ${n}_{Iterationen}^{( k )}$) die durchschnittliche Anzahl von Iterationen ( ${n}_{Iterationen}^{( k )}$) in Abhängigkeit von dem Signal/Rausch-Verhältnis als Durchschnittswert der Anzahl von Iterationen, die die iterative Decodierung für jeden Block einer Reihe von Blöcken mit der Größe der Teilgröße durchführen würden, bestimmt wird, wobei die Iterationen angehalten werden, wenn der Block mit der Größe der Teilgröße ein vorbestimmtes Zuverlässigkeitskriterium überprüft oder wenn die Anzahl von Iterationen für diesen Block die gegebene maximale Anzahl von Iterationen erreicht.

3. Optimierungsverfahren nach Anspruch 1 oder 2, **dadurch gekennzeichnet, dass**, die durchschnittlichen Anzahlen von Iterationen für verschiedene Größen der Teilgröße, verschiedene maximale Anzahlen von Iterationen und verschiedene Signal/Rausch-Verhältnisse in einer Tabelle gespeichert werden.

4. Optimierungsverfahren nach Anspruch 3, **dadurch gekennzeichnet, dass** die Tabelle im Verlauf der iterativen Decodierung aktualisiert wird.

5. Optimierungsverfahren nach Anspruch 3 oder 4, **dadurch gekennzeichnet, dass** die durchschnittlichen Anzahlen von Iterationen durch eine Interpolation aus in der Tabelle verfügbaren Daten erhalten werden.

6. Optimierungsverfahren nach einem der vorhergehenden Ansprüche, **dadurch gekennzeichnet, dass** die Suche auf die ganzen Zahlen beschränkt ist, die einen Wert haben, der größer als ein vorbestimmter Wert (kₘᵢₙ) ist.

7. Optimierungsverfahren nach einem der vorhergehenden Ansprüche, **dadurch gekennzeichnet, dass** es vor der Suche die maximale Anzahl von Iterationen ( ${n}_{Iterationen}^{( k )}$) für einen Block mit üblicher Größe bestimmt, die mit einer vorbestimmten maximalen Decodierungszeit vereinbar ist, und dass die Suche unter der Vielzahl von Größen (N/k) von Blöcken, die Teilgrößen sind, und der Vielzahl von ganzen Zahlen auf diejenigen Werte beschränkt ist, bei denen die durchschnittliche Anzahl von Iterationen ( ${n}_{Iterationen}^{( k )}$), die die iterative Decodierung an einem Block mit der Größe der Teilgröße durchführen würde, kleiner als die maximale Anzahl von Iterationen ( ${n}_{Iterationen}^{( k )}$) ist.

8. Verfahren zur iterativen Decodierung von codierten Daten, wobei die Blöcke eine Ausgangs- bzw. Endgröße haben, **dadurch gekennzeichnet, dass** es eine optimale Blockgröße und eine mit dieser Größe verbundene maximale Anzahl von Iterationen durch das Optimierungsverfahren nach einem der vorangehenden Ansprüche bestimmt, wobei die Daten eines Blocks mit ursprünglicher Größe als Folge von Unterblöcken mit optimaler Größe codiert wurden, und dass die Unterblöcke einzeln durch eine Reihe von Iterationen der iterativen Decodierung decodiert werden, wobei die Iterationen für einen Unterblock angehalten werden, wenn ein vorbestimmtes Zuverlässigkeitskriterium erfüllt ist oder wenn die Anzahl von Iterationen die mit der optimalen Größe verbundene maximale Anzahl von Iterationen erreicht.

9. Verfahren zur iterativen Decodierung von codierten Datenblöcken, wobei die Blöcke eine ursprüngliche Größe haben, **dadurch gekennzeichnet, dass** es eine optimale Blockgröße und eine mit dieser Größe verbundene maximale Anzahl von Iterationen durch das Optimierungsverfahren nach einem der vorangehenden Ansprüche bestimmt, wobei die Daten eines Blocks mit ursprünglicher Größe als Folge von Unterblöcken mit optimaler Größe codiert wurden, und dass die Unterblöcke decodiert werden, wobei nacheinander an jedem Unterblock eine Iteration der iterativen Decodierung durchgeführt wird, wobei für einen Unterblock keine Iteration durchgeführt wird, wenn die Anzahl von Iterationen die mit der optimalen Größe verbundene maximale Anzahl von Iterationen erreicht.

10. Vorrichtung zur iterativen Decodierung von von einem Turbocodierer codierten Datenblöcken, **dadurch gekennzeichnet, dass** sie Mittel zum Einsetzen des Optimierungsverfahrens nach einem der Ansprüche 1 bis 7 umfasst, wobei die Mittel eine optimale Blockgröße und eine maximale Anzahl von Iterationen pro Block mit optimaler Größe liefern, wobei die Vorrichtung ferner Mittel zur Übertragung von Information über die optimale Blockgröße zum Turbocodierer umfasst.

11. System zur Codierung/Decodierung mit einem Turbocodierer, der zum Codieren von Datenblöcken geeignet ist, und einer Vorrichtung zur iterativen Codierung nach Anspruch 10, die zum Decodieren von vom Turbocodierer codierten Datenblöcken geeignet ist, wobei dieser letztgenannte Mittel zum Empfangen der Information über die optimale Blockgröße und zum Verändem der Größe von mindestens einer internen Verschachtetungseinrichtung in Abhängigkeit von der empfangenen Information umfasst.

12. Vorrichtung zur Codierung von Datenblöcken, **dadurch gekennzeichnet, dass** sie Mittel zum Einsetzen des Optimierungsverfahrens nach einem der Ansprüche 1 bis 7 umfasst, wobei diese Mittel eine optimale Blockgröße liefern, wobei die Vorrichtung ferner Mittel zum entsprechenden Verändern der Größe der codierten Datenblöcke in Abhängigkeit von der optimalen Blockgröße umfasst.

13. Vorrichtung für eine Turbo-Gleichverteilung von von einem Codierer codierten und modulierten Datenblöcken, **dadurch gekennzeichnet, dass** sie Mittel zum Einsetzen des Optimierungsverfahrens nach einem der Ansprüche 1 bis 7 umfasst, wobei die Mittel eine optimale Blockgröße liefern, wobei die Vorrichtung ferner Mittel zum Weiterleiten von Information über die optimale Blockgröße zum Codierer umfasst.
